# EUROPEAN PATENT APPLICATION

(11) **EP 0 750 341 A1**
(43) Date of publication of application: **27.12.1996**
(21) Application number: 95830252.3
(22) Date of filing: 19.06.1995
(51) Int. Cl.: H01L 23/00, H01L 23/467, H01L 23/40

(54) **A releasable mount heat-sink for a very large scale integrated circuit**

(71) Applicant: BULL HN INFORMATION SYSTEMS ITALIA S.p.A., 10014 Caluso (Torino) (IT)
(72) Inventor: Spagna, Danilo, I-20017 RHO (Milano) (IT)
(74) Representative: Falcetti, Carlo

(57) **Abstract**

A highly efficient releasable mount heat-sink for a very large scale integrated circuit comprises a single piece (1) of a high thermal conductivity material formed of two mutually parallel plates (3,4) interconnected by a plurality of fins (2) lying across said plates to form a plurality of ducts for a refrigerating gas flow, the piece being formed with a plurality of housings (5,6,7,8) for means (16,17,18,19,20,21) of securing the heat-sink on a support (15) of the integrated circuit (14) with one (3) of the plates in contact with the integrated circuit (14).

## Description

The present invention relates to a releasable mount heat-sink for a very large scale integrated circuit.

It is known that advancements in electronic technologies have made very large scale integrated circuits, such as microprocessors, available commercially which afford ever higher speed of operation.

This involves increasingly higher power consumption by the circuits.

The power consumed is converted to heat, which must be dissipated if the circuits are not to be destroyed.

The problem is so important that certain electronic apparatus, such as supercalculators, have had to be equipped with liquid flow cooling systems to enhance their heat exchange efficiency.

This involves such constructional complexity, costs and drawbacks that this approach has been limited to special applications.

In general, the use of ambient air is preferred for the heat transfer and cooling fluid, and for better effectiveness, forced ventilation is employed where natural convection proves inadequate.

Since the exchange of heat between a heat-generating object such as an integrated circuit and a surrounding flow of fluid is related to the surface area of the object swept by the fluid, radiating fin heat-sinks have been developed which are made of a high thermal conductivity material, and once fitted to the integrated circuits in close physical contact relationship, expand the surface area of heat exchange with the fluid, thereby affording increased heat dissipation for the same thermal head.

Increased specific power consumption of the components has required the use of heat-sinks of ever larger size relative to the associated components and releasable-mount arrangements to provide a close physical contact of the electronic component with the heat-sink without introducing unacceptable mechanical stresses.

In all these types of heat-sinks, a flat plate contacting one face of the electronic component is provided with fins extending across the plate, usually parallel to one another to form flow channels through which a forced air stream can be directed.

The efficiency of these dissipators is heavily dependent on the angle at which the air flow impinges on the heat-sink fins.

Top efficiency is achieved when this angle of attack is zero; in that case, the air flow can be admitted with minimal load losses and at a maximal flow rate through the channel depth.

Otherwise, the air flow only tends to sweep over the fin tips without entering the channels formed thereby.

In view of that the air stream is generated in electronic apparatus by fans with significant turbulence, to be aggravated by the presence of the components to be cooled, the flow direction, while having on the average a predetermined orientation, is deeply different and varies over time between different points thereof.

This means, in any case, that the air flow impinging on the heat-sink will only partially penetrate the channels between the fins, and the desired optimum dissipation value cannot be obtained.

This limitation is obviated by the heat-sink of the present invention, which consists of an aluminum extrusion wherein two flat parallel radiating plates are joined to each other by a plurality of beads or fins lying perpendicular to both plates and parallel to one another and forming, in cooperation with both plates, a plurality of ducts having a substantially rectangular and constant cross-sectional shape and lying side-by-side, wherethrough the air flow is ducted with no chance of escaping once it has entered the various ducts.

In this way, for a given size of the heat-sink, using conventional heat-sinks, and for the same air flow velocity, much higher effectiveness, as well as unequalled performance stability and repeatability are achieved, which allow its use under extreme working conditions with no need to provide for safe margins.

Advantageously, the air flow ducts extend along the direction of greatest length of the heat-sink, whose shape is that of a right parallelepipedon measuring approximately 150x77x27 mm.

This boosts the flow ducting effect and makes the extrusion process easier and more economical to carry out using a smaller extrusion die. One of the largest faces forms, in its central portion, a generally square contact surface with a corresponding flat surface of the integrated component to which the heat-sink is fitted releasably.

An important aspect of removable heat-sinks is the arrangement for clamping the heat-sink to the integrated component.

The clamping arrangement is to ensure perfect contact between the component and the heat-sink with an evenly applied contact pressure, without producing local stresses which can damage the component.

Also, the clamping arrangement should have minimal space requirements, and as far as possible, should not interfere with the ventilation flow to the point of impairing its effectiveness.

Such results are obtained with the heat-sink of the present invention by milling in four housings for guide posts, compression springs and clamping screws near the four corners of the contact surface of the heat-sink with the integrated component.

Thus, the clamping arrangement can be contained within the heat-sink own outline and occupies no additional space.

Furthermore, it introduces no obstructions to the ventilation flow through the ducts.

The features and advantages of the invention will be more clearly apparent from the following description of a preferred embodiment thereof and the accompanying drawings, in which:
Figure 1 is a part-sectional plan view of the heat-sink, in relation to its mating plane with an integrated circuit;
Figure 2 is a side view of the heat-sink in Figure 1;
Figure 3 is a sectional view of the heat-sink taken along A-A in Figure 1;
Figure 4 is a sectional view of the heat-sink taken along B-B in Figure 1;
Figure 5 is an enlarged sectional view, taken along B-B in Figure 1, of a portion of the heat-sink, as fitted to an integrated circuit, and associated fasteners;
Figure 6 is a perspective view of a preferred embodiment of an electronic apparatus incorporating a plurality of heat-sinks according to the present invention.

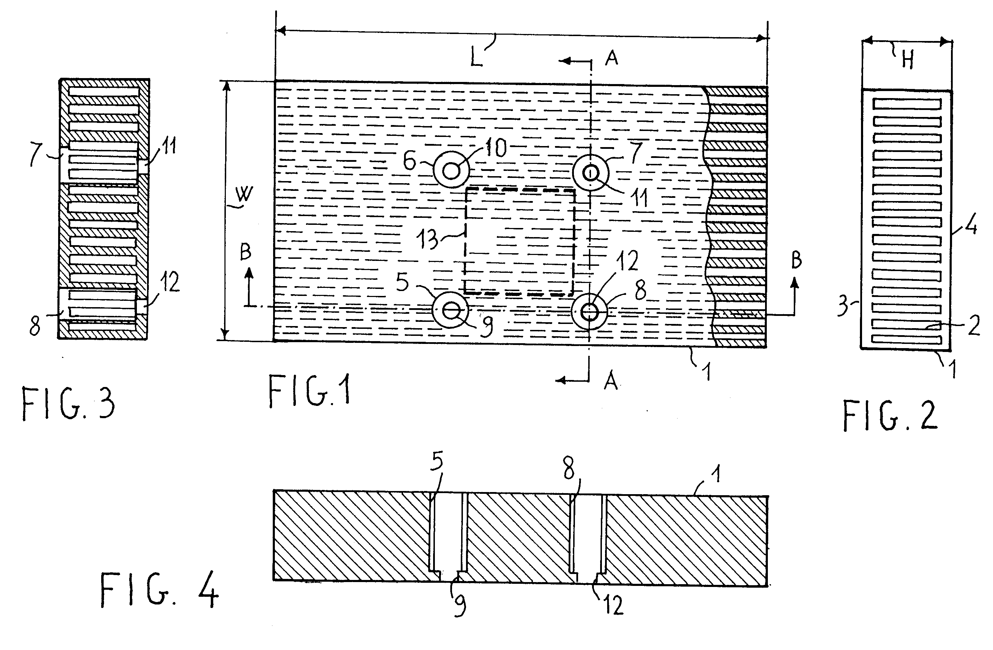

Referring to Figures 1 to 4, a heat-sink embodying the present invention comprises an integral aluminum extrusion 1 in the form of a right parallelepipedon having a length L, width W and height H, on whose interior a plurality of parallel ducts are formed which have a rectangular cross-sectional shape and are separated by parallel fins 2 extending perpendicularly between a lower plate 3 and an opposite upper plate 4 along the direction of the length L.

In a preferred embodiment, the heat-sink has the following dimensions: L=150 mm; W=77 mm; H=27 mm.

The plates 3 and 4 have the same thickness of 3.5 mm, and the fins are 2 mm thick.

The symmetry of the extruded section ensures true planarity for the plates 3 and 4 without warping, and simplifies the manufacturing process.

It will be apparent, however, that the extrusion could be asymmetrical in cross-section, for example, with the lower plate 3, intended to contact a juxtaposed electronic component, that may be thicker than the upper plate 4 or have a varying thickness crosswise to the extrusion direction coincident with the length L of the heat-sink.

The fins 2 may be equispaced and have the same thickness throughout, as shown, so as to form ducts with the same rectangular cross-section of 3x20 mm in the preferred embodiment described, or may be arranged at different spacings and have different thicknesses from one another so as to form ducts with different cross-sections.

However, the theoretical simulations and tests carried out have brought out no significant advantages over the simpler preferred embodiment shown in the Figures.

The heat-sink is expediently anodized black for better heat transfer efficiency.

To fit the heat-sink to an integrated electronic components such as a packaged chip of usual size, on the order of 31x31x6 mm, welded to a printed circuit support by a technique known as flip-chip bonding, the heat-sink is formed as by milling with four cylindrical housings 5, 6, 7, 8 having their axes in the direction of the height H of the heat-sink, which extend through the thickness of the upper plate 4 and span the full height of the fins 2. The lower plate 3 is formed with cylindrical clearance openings 9, 10, 11, 12, coaxial with the housings 5, 6, 7, 8, for pins which secure the heat-sink on a printed circuit support to which the component to be cooled is welded.

Illustratively, the housings 5, 6, 7, 8 may have a diameter of 10-11 mm and the openings 9, 10, 11, 12 a diameter of 6-7 mm.

The openings 9, 10, 11, 12 are suitably located at the corners of a square which encloses a square surface 13 of the plate 3 intended to contact the electronic component to be cooled, a suitable distance away from the surface 13 to avoid interference of the securing pins with the component.

Illustratively, if the area occupied by the component in the plane of the plate 3 is of 31x31 mm, then the openings 9, 10, 11, 12 may be located with their axes at the corners of a square whose side length is on the order of 42-43 mm.

As shown in the Figures, the contact surface 13 of the plate 3 need not be centered on the plate, and may be offset somewhat to fill specific demands.

It is preferable, though, if the milled housings 5, 6, 7, 8 do not break the continuity of the outermost fins on the heat-sink so as to leave openings through which the ducted cooling flow can escape.

It also is preferable that the axes of the housings 5, 6, 7, 8 be aligned as far as possible to the centerline of one of the fins, so as to minimize any interference of the fasteners with the cooling flow.

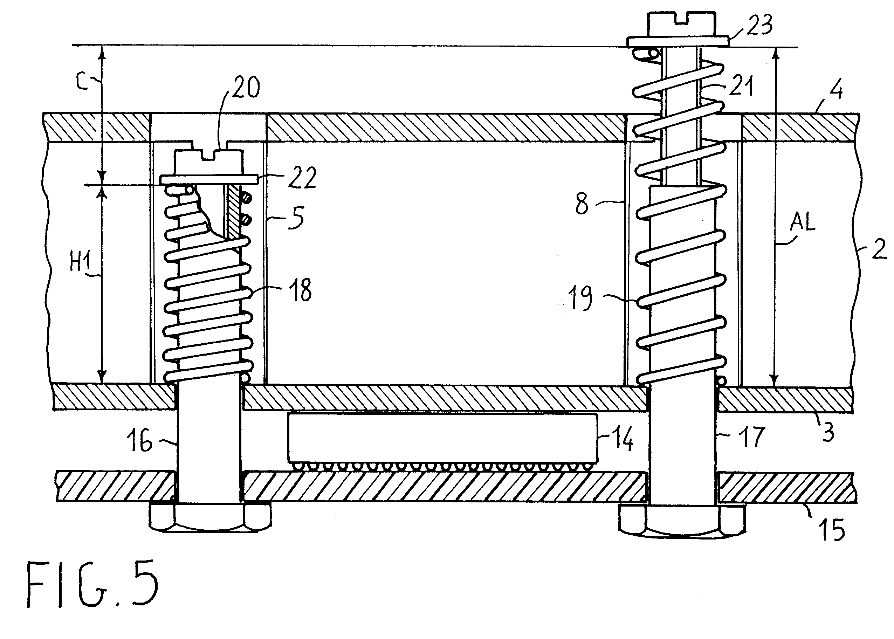

Figure 5 shows a section taken along B-B in Figure 1 through the heat-sink, and an arrangement for securing the heat-sink on a printed circuit support of the electronic component to be cooled.

An integrated circuit component 14, of the flip-chip type, is welded to a printed circuit support 15 by conventional techniques (thermocompression or ultrasonic welding).

The printed circuit board 15 is provided with suitable openings (four openings, of which two are shown) through which heat-sink locating and securing pins are inserted.

The heat-sink is disposed on the integrated circuit 14 with the lower plate 3 in contact with the top face of the integrated circuit 14.

The pins 16, 17 are provided with a holding head on the opposite face of the printed circuit board 15 from that carrying the integrated circuit 14 and extend through the openings in the plate 3 into the housings 5, 8 to a height H1 which is expediently less than the housing depth.

Coiled around the portion of the pins 16, 17 which is inserted into the housings, is a compression coil spring 18, 19, respectively, which bears with one end on the housing bottom.

The pins 16, 17 are formed with a threaded cylindrical cavity coaxial with the pin, wherein a screw 20, 21, respectively, is threaded which has a lockwasher 22, 23 respectively compressing the spring 18, 19.

Thus, the springs 18, 19 exert on the plate 3 a pressure which forces the plate into full contact with the top face of the integrated circuit 14 and to take the same angle of attack.

The force exerted by each spring is substantially proportional to the amount of imposed shrinkage C, which is equal to the difference between the axial length AL of the relaxed spring and the height H1 of the locating pin in its housing.

The height H1 may differ between pins to accommodate a possible parallelism error between the plate 3 and the printed circuit support 15 due to the integrated circuit 14.

This difference in the height H1 is at all events on the order of tenths of a millimeter, whereas the shrinkage caused in the springs may be on the order of ten millimeters, so that assembly inaccuracies and production tolerances will not affect to any significant extent the amount of shrinkage and the corresponding force exerted by the spring, which can be predetermined with great accuracy.

It follows that the combined pressure of the various springs, four in number, is accurately defined as to point of application, direction and amount, and is centered true on the integrated circuit 14, giving rise to an even pressure distribution across the same and the raised welds.

In practice, since the printed circuit support has a smaller bend resisting section than the heat sink and the force individually exerted by the various springs on the printed circuit support is offset from the reaction exerted by the integrated circuit, a support deflection occurs which tends to distribute the contact pressure betwen the integrated circuit and the printed circuit board at the edges of the integrated circuit where the raised welds locate. However, the deflection is limited such that the resultant local stresses are quite acceptable, even with a combined spring force on the order of 100-200 newtons.

The foregoing description only covers a preferred embodiment of the heat-sink, and it should be understood that many changes may be made thereunto.

For example, the heat-sink could be cast rather than extruded, in which case the thickness of both the plates and the fins can be controlled such that the thickness is greatest in the central zone of the heat-sink and tapers toward the entries of the flow ducts.

This expedient, inter alia, produces a non-zero rake angle and makes for easier separation of the dies and shakeout of the piece from the die.

With a formed heat-sink, it is apparent that the openings for the fixing arrangement can be produced during the forming operation itself.

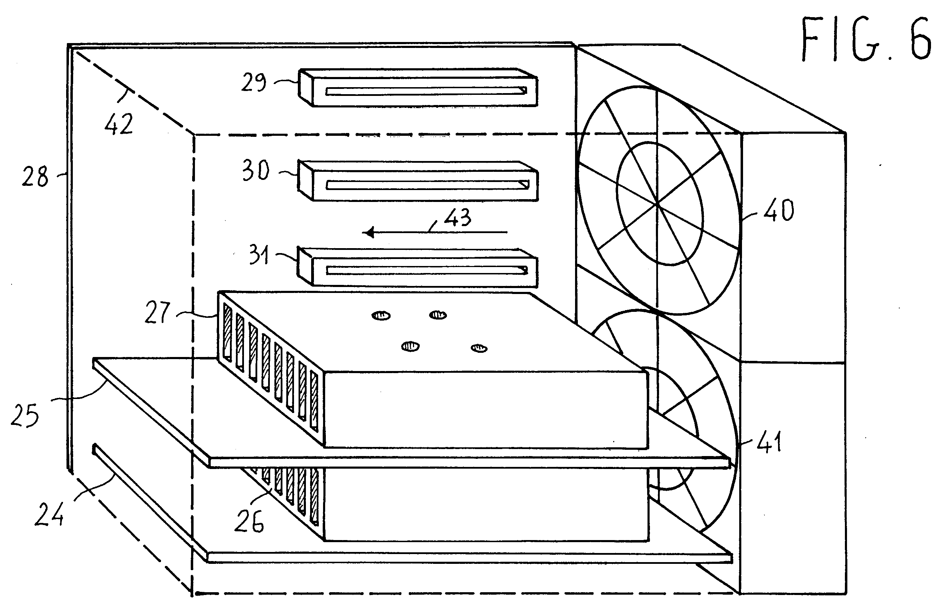

Figure 6 is a perspective view of an embodiment of an electronic apparatus, e.g. a data processing system using heat-sinks of the kind described above.

A bank of, for example, two fans 40, 41 are arranged on a side, front or rear wall of an electronic apparatus cabinet, shown removed by the phantom line 42 to expose its interior, and generate a turbulent flow of ventilation air in the general direction of an arrow 43.

The cabinet 42 accommodates a plurality of printed circuit boards, or boards 24, 25, lying in the same direction as the air flow.

The boards carry a plurality of electronic components each, of which at least one, at a very large scale of integration, requires dissipation of a large amount of thermal power, on the order of tens of watts.

Each of the high-dissipation electronic components has a heat-sink 26, 27 of the kind described above associated therewith and disposed parallel to the boards with the ventilation channels oriented in the same direction as the air flow 43.

The various boards 24, 25 are supported on a mother board or back panel 28 extending perpendicularly to the boards 24, 23 and being provided with connectors, such as 29, 30, 31, for the mechanical attachment and the electrical interconnection of the various boards.

The spacing of the various boards 24, 25, lying parallel to one another, is expediently equal to, or only slightly greater than, the outline of the heat-sinks perpendicularly to the boards.

Thus, the various boards 24, 25 accommodated within the cabinet 42 form, with the cabinet walls, a plurality of ducts through which the air flow 43 is distributed.

A significant portion of the cross-section of these ducts is occupied by the heat-sinks 26,27, whose internal ducts further direct the air flow along a constrained flow path.

It is apparent that the opposite wall of the cabinet 42 from that mounting the fans is provided with outflow grilles for the cabinet ventilation air.

It also is apparent that, with the cabinet 42 suitably held off a rest surface, the fans 40, 41 could be placed at the cabinet bottom, and the boards 24, 25 arranged vertically rather than horizontally.

## Claims

1. A releasable mount heat-sink for a very large scale integrated circuit (14), comprising a single piece (1) of a high thermal conductivity material formed of two mutually parallel plates (3,4) interconnected by a plurality of fins (2) extending across said plates (3,4) to form a plurality of ducts for a refrigerating gas flow, said piece (1) being formed with a plurality of housings (5,6,7.8) for means (16,17,18,19,20,21) of securing said heat-sink on a support (15) of said integrated circuit (14), with one of said heat-sink plates (3,4) in contact with said integrated circuit (14).

2. The heat-sink of Claim 1, wherein said plates (3,4) are rectangular and have the same thickness, and said fins (2) lie parallel to one another and perpendicular to said plates (3,4).

3. The heat-sink of Claim 2, wherein said housings (5,6,7,8) comprise a tetrad of cylindrical cavities having axes perpendicular to said plates and being formed through one (4) of said plates and extending through said fins (2) to the other (3) of said plates, said other plate (3) being formed with a tetrad of cylindrical openings (9,10,11,12), each lying coaxial with one of said cylindrical cavities and having a smaller diameter.

4. The heat-sink of Claim 3, comprising securing means, said securing means consisting of a tetrad of securing pins (16,17) with a threaded hollow head inserted into said cylindrical cavities through said cylindrical openings (9,10,11,12), a tetrad of axial compression coil springs being each received in one of said cylindrical cavities and compressed between said other heat-sink plate (3) and a head of a screw (20,21) threaded into said threaded hollow head of a securing pin (16,17).
